# EUROPEAN PATENT SPECIFICATION

(11) **EP 1 889 302 B1**
(45) Date of publication and mention of the grant of the patent: **30.12.2009**
(21) Application number: 06744905.8
(22) Date of filing: 10.05.2006
(51) Int. Cl.: H01L 33/00

(54) **ILLUMINATION SYSTEM WITH LEDS**
BELEUCHTUNGSSYSTEM MIT LEDs
SYSTEME D'ECLAIRAGE POURVU DE DIODES ELECTROLUMINESCENTES (DEL)

(30) Priority: 25.05.2005 EP 05104461
(43) Date of publication of application: 20.02.2008
(73) Proprietor: Koninklijke Philips Electronics N.V., 5621 BA Eindhoven (NL)
(72) Inventor: WOLF, Ronald, M., NL-5656 AA Eindhoven (NL); DE GRAAF, Jan, NL-5656 AA Eindhoven (NL); VAN SPRANG, Hans, NL-5656 AA Eindhoven (NL); VERSCHUUREN, Marcus, A., NL-5656 AA Eindhoven (NL); KOP, Theo, A., NL-5656 AA Eindhoven (NL)
(74) Representative: Bekkers, Joost J.J
(86) International application number: PCT/IB2006/051474
(87) International publication number: WO 2006/126123

(56) References cited:
- EP-A- 0 526 776
- US-A1- 2004 027 067
- US-B1- 6 838 702
- PATENT ABSTRACTS OF JAPAN vol. 2003, no. 12, 5 December 2003 (2003-12-05) -& JP 2004 158557 A (SHURAI KAGI KOFUN YUGENKOSHI), 3 June 2004 (2004-06-03) cited in the application

## Description

The invention relates to an illumination system comprising at least one light-emitting diode (LED) chip, each light-emitting diode chip comprising a LED substrate provided with a light-emitting layer for emitting light, the at least one light-emitting diode chip being arranged on an optical substrate.

Currently LEDs are widely used in illumination systems. They are used, inter alia, as light sources in backlighting of (non-emissive) (image) display devices, for example for television receivers and monitors. Such illumination systems can particularly suitably be used as a backlight for non-emissive displays, such as liquid crystal display devices, also referred to as LCD panels, which are used in (portable) computers or (cordless) telephones. In addition, such illumination systems are used for general lighting purposes, such as spot lights, flood lights and for large-area direct-view light emitting panels such as applied, for instance, in signage, contour lighting, and billboards. Additional applications include automotive front, signal lighting, and so-called ambiance-light applications to adapt ambient light conditions to the mood of a TV show or movie shown on a screen at home. Other emerging applications are the use of LED's as high brightness sources for personal image projection devices, where high brightness, high flux sources are preferred.

Generally, such illumination systems comprise a multiplicity of light sources, for instance light-emitting diodes (LEDs). LEDs can be light sources of distinct primary colors, such as, for example the well-known red (R), green (G), or blue (B) light emitters. In addition, the light emitter can have, for example, amber or cyan as primary color. These primary colors may be either generated directly by the light-emitting-diode chip, or may be generated by a phosphor upon irradiance with light of shorter wavelength from the light-emitting-diode chip. In the latter case, also the use of mixed colors or white light is possible as one of the primary colors. Generally, the light emitted by the individual light sources is mixed in the transparent element(s) of the optical system to obtain a uniform distribution of the light while eliminating the correlation of the light emitted by the illumination system to a specific light source. In order to obtain constant optical performance over life measures must be taken to compensate for the different ageing behavior of each of the individual light sources in the illumination system. To this aim a controller with a sensor and some feedback algorithm is supplied to stabilize color accuracy as well as the light output level over the life of the light source.

The English Abstract of JP Patent Application JP-A 2004-158557 discloses a flip-chip type light-emitting diode (LED) package comprising a transparent substrate having a first surface with a recess and a LED placed in the recess. The LED emits light towards the transparent substrate as in a flip-chip die, so that the emission can not be obstructed by a bonding pad at the upper portion of the LED, thereby increasing the emission area and increasing emission intensity.

US 2004/0027067 discloses a LED which can be mounted at high density on a large area display. The LED is arranged on a secondary ceramic sheet which is stacked on a ceramic substrate. The ceramic substrate comprises a hole for a heat sink. The ceramic substrate further comprises electrodes which are electrically connected to the LED. The chip is sealed with transparent insulating resin The LED transmits the light via the insulating layer and not via the ceramic sheet.

EP 0 526 776 discloses an optoelectronic package with direct free space optical communication between pairs of optical transmitters and receivers located on different substrate surfaces in a closely spaced stack of chip carrying substrates. The transmitters and receivers are aligned so that the light beam from each transmitter follows an optical path toward its respective receiver. The stack of substrates, the transmitters and receivers are mounted on the surface of the substrates, many of which are separated by intervening substrates. These intervening substrates have vias, holes or transparent regions, or other optical means, at locations along the optical paths connecting the transmitters and receivers. Heat is removed via the substrates, which are made e.g. from glass.

A drawback of the known illumination system is that the efficacy of the light emission is relatively low.

The invention has for its object to eliminate the above disadvantage wholly or partly. According to the invention, this object is achieved by an illumination system according to claim 1.

There is a tendency in illumination systems comprising light-emitting-diodes (LED) to increase the (power) output level of the LED chips. Such LED chips when driven at nominal power have a radiant power output in the range from 100 mW to 5 W. This may result in temperatures of the LEDs which may rise to temperatures well above 100°C, or even above 200°C. It is known that the efficacy of certain LED chips decreases when the temperature of the LED chip becomes too high while at still higher temperatures the functionality of the LED decreases. By providing according to the measure of the invention the optical substrate with a heat-spreading means, the LEDs can be operated at high powers while heat generated by the LEDs is guided away from the LED by the heat-spreading means.

A problem of current single and multiple LED light sources in illumination systems known in the art is the relatively low efficiency of conversion of input electric power to emitted optical power. For the more efficient sources, this conversion efficiency amounts to 10-15 % at most. The low efficiency is on the one hand due to intrinsic conversion efficiency in the active layer of the LED and on the other hand due to light trapping and reabsorption in the same active layer or in stacks of high-index layers surrounding it. This amounts in 90-85% of the input power being converted into heat. For this reason both thermal management and optimization of light-extraction from the LED are important issues in optimizing LED's for lighting applications.

A further drawback of the known illumination system is that the illumination system is not designed for power chips having no means to effectively transfer heat away from the chips and therefore the lumen flux and luminance of this system remains low. Furthermore, the efficacy of the light emission is relatively low, because the combination of substrate and LED is not optimized for extraction of the light from the LED.

Preferably, the LEDs according to the invention have a radiant power output of at least 100 mW when driven at nominal power.

In the illumination system according to the invention the light-emitting diode is mounted in a so-called face-down manner on the optical substrate. Light emitted by the LED is coupled into the optical substrate.

There are several ways in which the heat-spreading means can be realized. An embodiment of the illumination system according to the invention is characterized in that the optical substrate comprises a translucent or transparent polycrystalline ceramic material, acting both as an optical component and as heat-spreading means. An optical substrate made from a (poly)crystalline ceramic material is itself effective as a heat-conductive component. Another advantage of employing an optical substrate made from a polycrystalline ceramic material is that such materials readily withstand temperatures above 200°C, high-power LED chips can be employed and temperature is no longer a constraint of the illumination system. In order to be an integral part of the optical system the (poly)crystalline ceramic material should be transparent or translucent. For practical reasons the use of sintered polycrystalline optical substrates is preferred. The preparation of such components is known to be possible to those skilled in the art of preparing ceramic components or devices. Suitable ceramic material are Yttrium Aluminium Granate (YAG), PCA (polycrystalline Alumina), A1N (Aluminium Nitride) etc. These materials are sintered at temperatures above 1000°C and can easily withstand operating temperatures of the LED. Also is known that components of these materials can be formed in various shapes by extrusion, injection molding or e.g. casting techniques as known to those skilled in the art of ceramic shaping. Glass is another suitable material as optical substrate.

Using the above-mentioned material, additional functions can be added to the optical substrate. To this end a preferred embodiment of the illumination system according to the invention is characterized in that the pre-determined optical properties of the optical substrate comprise influencing light extraction, light conversion and/or light directionality.

In a first embodiment a blue or UV-emitting LED is mounted in a recess where locally a certain amount is applied of a luminescent substance. This can be sintered in the ceramic material or be applied later through in-diffusion or by any other means known to those skilled in the art. The luminescent material converts at least partly the primary light to a secondary color and by combining various luminescent substances in an optical substrate for a single LED a very robust constant color light source is obtained.

In another embodiment a multiplicity of LEDs is mounted in various egress holes supplied with the same or different luminescent material in order to obtain a higher light flux from the source. By deliberately choosing the distribution of the luminescent substance over the ceramic substrate it is also possible to induce a desired change of color or color temperature of the light emitted from the optical substrate as a function of position or emission angle.

In yet another preferred embodiment, the ceramic substrate consists of a material that has the same or approximately the same refractive index as the substrate of the LED. By applying a transparent adhesive between the inside of the egress hole and the LED substrate with the same refractive index the device minimizes the loss of light by internal reflection in the LED substrate.

In still another embodiment the front surface of the optical substrate is supplied with optical structures like micro-lenses or diffraction patterns that aim at facilitating extraction of light or also at enhancing extraction in a pre-specified direction. These patterns can be applied to the surface of the optical substrate through which the light is emitted by means of structuring the ceramic before sintering or by applying a layer with a suitable refractive index on top of the optical substrate afterwards. In all cases this concerns an inorganic layer suitable to withstand operating temperatures of 300°C or higher.

Another advantage of illumination system according to the present invention is that on top of the improved heat conductivity of the ceramic layer, there are other means to stimulate heat spreading in the illumination system. To this end a preferred embodiment of the illumination system according to the invention is characterized in that the heat-spreading means comprises a metallization layer applied at a side of the optical substrate facing away from the light-egress window. The metallization layer further promotes guiding heat away from the LEDs. The light emitted by the LEDs being guided into the optical substrate, the metallization layer applied at a side of the optical substrate facing the light-emitting layer does not reduce the efficacy of the light emission by the LEDs. The metallization layer can be used as a reflector to guide emitted light into the side of the light-egress window.

A preferred embodiment of the illumination system according to the invention is characterized in that the heat-spreading means comprises a heat sink applied at a side of the optical substrate facing away from the light-egress window. A heat sink largely stimulates the transfer of dissipated energy to the ambient. Cooling for power application is effectively achieved by providing a heat sink.

A preferred embodiment of the illumination system according to the invention is characterized in that the at least one light-emitting diode chip is embedded in the optical substrate. An embedded environment of the LED and the provision of heat-spreading means contribute to more effective cooling the heat generated by the LED in operation.

Preferably, metal connects are provided on a side of the optical substrate facing away from the light-egress window, the metal connects powering the at least one light-emitting diode chip.

A favourable embodiment of an illumination system according to the invention is characterized in that a transparent optical-bonding means is provided between the at least one light-emitting diode chip and the optical substrate.

These and other aspects of the invention are apparent from and will be elucidated with reference to the embodiments described hereinafter.

In the drawings:
Fig. 1A is a cross-sectional view of an embodiment of the illumination system according to the invention where LEDs are mounted on the optical substrate;
Fig. 1B is a cross-sectional view of a detail of the embodiment shown in Figure 1A;
Fig. 2A is a cross-sectional view of an embodiment of the illumination system according to the invention where LEDs are embedded in the optical substrate;
Fig. 2B is a cross-sectional view of a detail of a first embodiment shown in Figure 2A, and
Fig. 2C is a cross-sectional view of a detail of a second embodiment shown in Figure 2A.

The Figures are purely diagrammatic and not drawn to scale. Notably, some dimensions are shown in a strongly exaggerated form for the sake of clarity. Similar components in the Figures are denoted as much as possible by the same reference numerals.

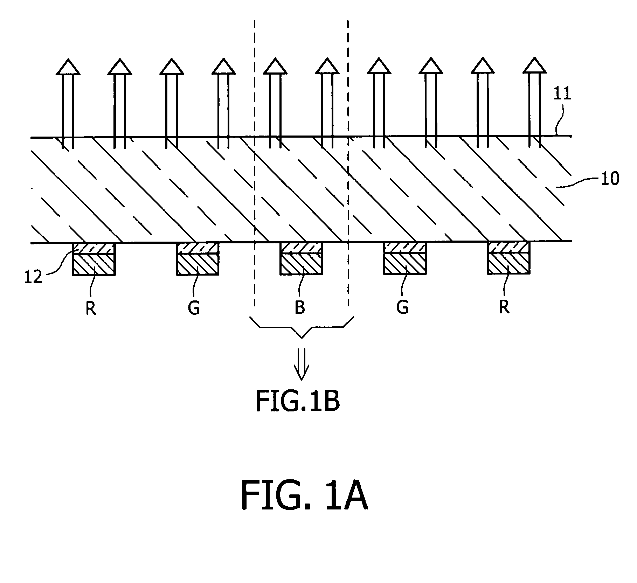

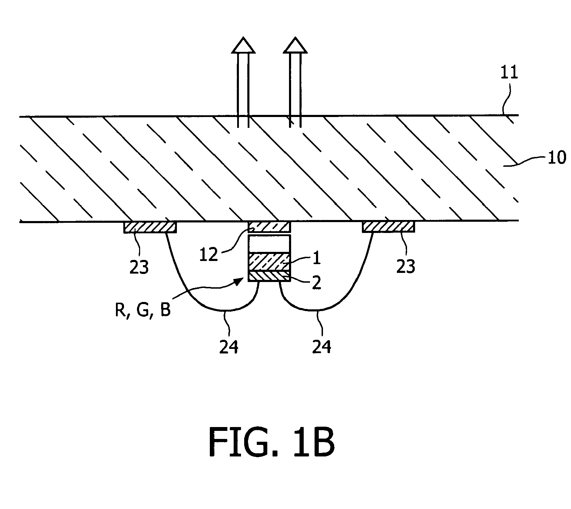

Figure 1A very schematically shows a cross-sectional view of an embodiment of the illumination system according to the invention. Figure 1B very schematically shows a cross-sectional view of a detail of the embodiment shown in Figure 1A. The illumination system in Figures 1A and 1B comprises a plurality of light-emitting diode (LED) chips R, G, B. In the embodiment of the invention shown in Figures 1A and 1B, the LED chips R, G, B are mounted on the optical substrate 10. LEDs can be light sources of distinct primary colors, such as in the example of Figure 1A, the well-known red R, green G, or blue B LED chips. Alternatively, the LEDs can have, for example, amber or cyan as primary color. The primary colors may be either generated directly by the light-emitting-diode chip, or may be generated by a phosphor (layer) upon irradiance with light from the light-emitting-diode chip. In the latter case, also mixed colors or white light is possible as one of the primary colors. In general, the LEDs have a relatively high source brightness.

Preferably, each of the LEDs has a radiant power output of at least 100 mW when driven at nominal power. LEDs having such a high output are often also referred to as LED power packages. The use of such high-efficiency, high-output LEDs has the specific advantage that, at a desired, comparatively high light output, the number of LEDs may be comparatively small. This has a positive effect on the compactness and the efficiency of the illumination system to be manufactured.

Each LED chip R, G, B comprises a LED substrate 2 provided with a light-emitting layer 1 for emitting light (see Figure 1B). The plurality of LEDs R, G, B is arranged on an optical substrate 10 with pre-determined optical properties. The pre-determined optical properties of the optical substrate encompass influencing light extraction, light conversion and/or light directionality.

In the illumination system according to the invention the LEDs R, G, B are mounted in a so-called face-down manner on the optical substrate 10. Light emitted by each LED R, G, B is coupled into the optical substrate 10. The light emitted by the plurality of LEDs R, G, B is emitted via a light-egress window 11 of the optical substrate 10 (see the arrows in Figure 1A and 1B). According to the invention the optical substrate 10 comprises heat-spreading means. In the example of Figure 1A and 1B, the optical substrate 10 itself acts as heat-spreading means. By providing an optical substrate 10 made from a translucent polycrystalline ceramic material, such ceramic material acts as the heat-spreading means. An optical substrate 10 made from a polycrystalline ceramic material effectively stimulates heat conduction. Another advantage of employing an optical substrate 10 made from a polycrystalline ceramic material is that such materials readily withstand temperatures above 200°C, high-power LED chips R, G, B can be employed and temperature is no longer a constraint of the illumination system. Preferably, the polycrystalline ceramic material is transparent. Suitable materials are Yttrium Aluminium Granate (YAG), PCA (polycrystalline Alumina), A1N (Aluminium Nitride) etc. These materials are sintered at temperatures above 1000°C and can easily withstand operating temperatures of the LED. Also is known that components of these materials can be formed in various shapes by extrusion, injection molding or e.g. casting techniques as known to those skilled in the art of ceramic shaping. The thermo-mechanic properties of the ceramic materials match with the LED chips, which enables a robust device design. Another suitable material as optical substrate is glass.

In the example of Figures 1A and 1B, metal connects 23 are provided on a side of the optical substrate 10 facing away from the light-egress window 11. The metal connects 23 power the plurality of LED chips R, G, B. Wire bonds 24 provide electrical connection between the LED chip R, G, B and the metal connects 23.

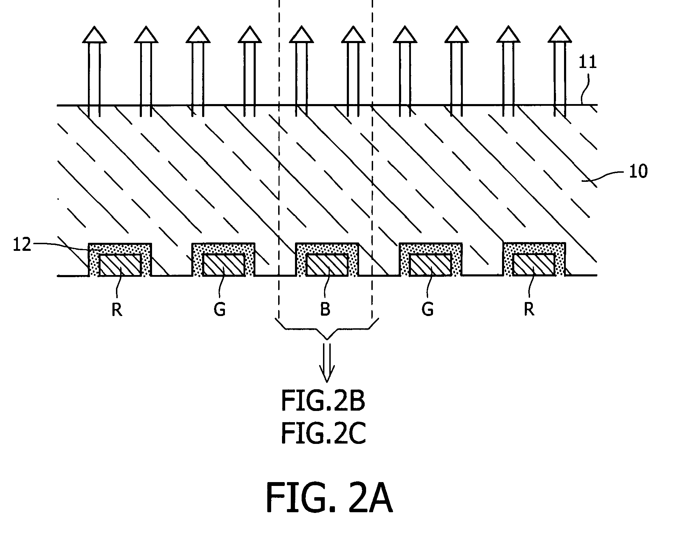

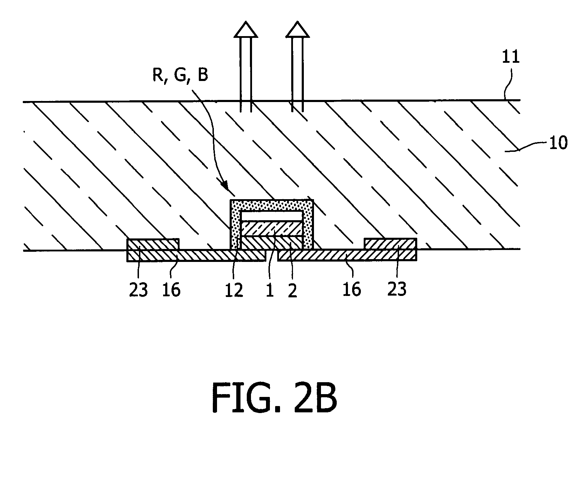

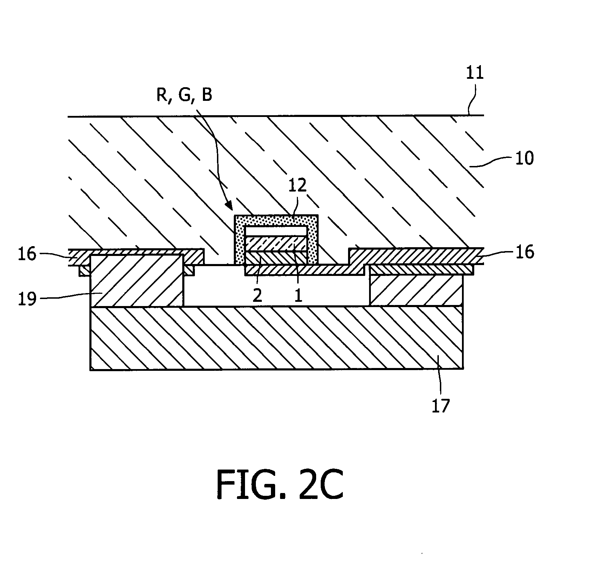

Figure 2A very schematically shows a cross-sectional view of an embodiment of the illumination system according to the invention where the LEDs R, G, B are embedded in the optical substrate 10. Figures 2B and 2C very schematically show a cross-sectional view of a detail of two different embodiments of the illumination system shown in Figure 2A.

The LEDs R, G, B are mounted in a so-called face-down manner in the optical substrate 10. Light emitted by each LED R, G, B is coupled into the optical substrate 10. The light emitted by the plurality of LEDs R, G, B is emitted via a light-egress window 11 of the optical substrate 10 (see the arrows in Figure 2A, 2B and 2C). An optical-bonding means 12 is provided between the LED chips R, G, B and the optical substrate 10. The optical-bonding means 12 provides a good optical contact between the LEDs and the optical substrate. Preferably, the optical bonding means comprises refractive-index matching properties for reducing or avoiding a change in refractive index between the LED chips R, G, B and the optical substrate 10. Preferably, the optical-bonding means 12 comprises transparent glue.

In the example of the illumination system as shown in Figure 2B, the heat-spreading means comprises a metallization layer 16 applied at a side of the optical substrate 10 facing away from the light-egress window 11. The metallization layer 16 provides electrical connection between the LED chips R, G, B and the metal connects 23. In the example of Figure 2B, the metal connects 23 are embedded in the optical substrate 10. The metallization layer 16 guides heat away generated by the LEDs.

In the example of the illumination system as shown in Figure 2C the heat-spreading means additionally comprises a heat sink 17 applied at a side of the optical substrate 10 facing away from the light-egress window 11. The metallization layer 16 is connected to the heat sink 17 via a relatively thick metallization plate 19. The heat generated by the LEDs R, G, B is effectively dissipated by heat conduction via the metallization plate 19 towards the heat sink 17 which radiated the heat to the ambient. In a favorable embodiment of the illumination system, the heat sink 17 is in contact with a housing of the illumination system via a heat-conducting connection.

The invention may be implemented by means of hardware comprising several distinct elements, and by means of a suitably programmed computer. In the device claim enumerating several means, several of these means may be embodied by one and the same item of hardware.

## Claims

1. An illumination system comprising:
at least one light-emitting diode chip (R, G, B),
each light-emitting diode chip (R, G, B) comprising a LED substrate (2) provided with a light-emitting layer (1) for emitting light,
the at least one light-emitting diode chip (R, G, B) being arranged on an optical substrate (10),
the light-emitting layer (1) of the at least one light-emitting diode chip (R, G, B) facing the optical substrate (10),
light emitted by the at least one light-emitting diode chip (R, G, B) being emitted via a light-egress window surface (11) of the optical substrate (10), the light-egress window surface (11) facing away from light-emitting layer (1),
the optical substrate (10) comprising a heat-spreading means, wherein that optical substrate (10) comprises a translucent material; the translucent material acting as heat-spreading means, the translucent material being translucent for the light emitted by the light emitting diode chip (R, G, B),
**characterized in that** translucent material is polycrystalline ceramic.

2. An illumination system as claimed in claim 1, wherein the translucent polycrystalline ceramic material are selected from the group comprising Yttrium Aluminum Granite, Polycrystalline Alumina, and Aluminum Nitride.

3. An illumination system as claimed in claim 1 or 2, wherein the heat-spreading means comprises a metallization layer (16) applied at a side of the optical substrate (10) facing away from the light-egress window surface (11).

4. An illumination system as claimed in claim 1 or 2, wherein the heat-spreading means comprises a heat sink (17) applied at a side of the optical substrate (10) facing away from the light-egress window surface (11).

5. An illumination system as claimed in claim 1 or 2, wherein the at least one light-emitting diode chip (R, G, B) is embedded in the optical substrate (10).

6. An illumination system as claimed in claim 1 or 2, wherein the optical substrate (10) comprises:
- luminescent material for converting at least part of the light emitted by the light-emitting diode chip (R, G, B) into light of a different color, and/or
- a refractive index substantially equal to the refractive index of the light-emitting diode chip (R, G, B), and/or
- optical structures selected from the group comprising micro-lenses and diffraction patterns.

7. An illumination system as claimed in claim 1 or 2, wherein metal connects (23) are provided on a side of the optical substrate (10) facing away from the light-egress window surface (11), the metal connects (23) powering the at least one light-emitting diode chip (R, G, B).

8. An illumination system as claimed in claim 1 or 2, wherein a transparent optical-bonding means (12) is provided between the at least one light-emitting diode chip (R, G, B) and the optical substrate (10), the transparent optical bonding means comprising refractive-index matching properties for reducing or avoiding a change in refractive index between LED chips R,G,B and the optical substrate.

9. An illumination system as claimed in claim 1 or 2, wherein at least one light-emitting diode chip (R, G, B) has a radiant power output of at least 100 mW when driven at nominal power.

## Patentansprüche

1. Beleuchtungssystem mit:
mindestens einem Leuchtdiodenchip (R, G, B),
wobei jeder Leuchtdiodenchip (R, G, B) ein LED-Substrat (2) umfasst, welches mit einer Licht emittierenden Schicht (1) versehen ist, um Licht zu emittieren,
wobei der mindestens eine Leuchtdiodenchip (R, G, B) auf einem optischen Substrat (10) angeordnet ist,
wobei die Licht emittierende Schicht (1) des mindestens einen Leuchtdiodenchips (R, G, B) dem optischen Substrat (10) zugewandt ist,
wobei von dem mindestens einen Leuchtdiodenchip (R, G, B) emittiertes Licht über eine Lichtaustrittsfensteroberfläche (11) des optischen Substrats (10) emittiert wird, wobei die Lichtaustrittsfensteroberfläche (11) von der Licht emittierenden Schicht (1) abgewandt ist,
wobei das optische Substrat (10) ein Wärmeausbreitungsmittel umfasst,
wobei das optische Substrat (10) ein lichtdurchlässiges Material umfasst, wobei das lichtdurchlässige Material als Wärmeausbreitungsmittel wirkt, wobei das lichtdurchlässige Material für das von dem Leuchtdiodenchip (R, G, B) emittierte Licht lichtdurchlässig ist, **dadurch gekennzeichnet, dass** das lichtdurchlässige Material polykristallines, keramisches Material ist.

2. Beleuchtungssystem nach Anspruch 1, wobei das lichtdurchlässige, polykristalline, keramische Material aus der Gruppe, umfassend Yttrium-Aluminium-Granat, polykristallines Aluminiumoxid und Aluminiumnitrid, ausgewählt wird.

3. Beleuchtungssystem nach Anspruch 1 oder 2, wobei das Wärmeausbreitungsmittel eine Metallisierungsschicht (16) umfasst, die auf einer der Lichtaustrittsfensteroberfläche (11) abgewandten Seite des optischen Substrats (10) aufgetragen wird.

4. Beleuchtungssystem nach Anspruch 1 oder 2, wobei das Wärmeausbreitungsmittel eine Wärmesenke (17) umfasst, die auf einer der Lichtaustrittsfensteroberfläche (11) abgewandten Seite des optischen Substrats (10) aufgebracht wird.

5. Beleuchtungssystem nach Anspruch 1 oder 2, wobei der mindestens eine Leuchtdiodenchip (R, G, B) in dem optischen Substrat (10) eingebettet ist.

6. Beleuchtungssystem nach Anspruch 1 oder 2, wobei das optische Substrat (10) umfasst:
- lichtdurchlässiges Material, um zumindest einen Teil des von dem Leuchtdiodenchip (R, G, B) emittierten Lichts in Licht einer anderen Farbe umzuwandeln, und/oder
- einen Brechungsindex, der im Wesentlichen dem Brechungsindex des Leuchtdiodenchips (R, G, B) entspricht, und/oder
- optische Strukturen, die aus der Gruppe, umfassend Mikrolinsen und Beugungsbilder, ausgewählt werden.

7. Beleuchtungssystem nach Anspruch 1 oder 2, wobei Metallverbindungen (23) auf einer von der Lichtaustrittsfensteroberfläche (11) abgewandten Seite des optischen Substrats (10) vorgesehen sind, wobei die Metallverbindungen (23) den mindestens einen Leuchtdiodenchip (R, G, B) speisen.

8. Beleuchtungssystem nach Anspruch 1 oder 2, wobei ein transparentes ,Optical-Bonding'-Mittel (12) zwischen dem mindestens einen Leuchtdiodenchip (R, G, B) und dem optischen Substrat (10) vorgesehen ist, wobei das transparente ,Optical-Bonding'-Mittel Brechungsindexanpassungseigenschaften umfasst, um eine Änderung des Brechungsindex zwischen LED-Chips R,G,B und dem optischen Substrat zu reduzieren oder zu vermeiden.

9. Beleuchtungssystem nach Anspruch 1 oder 2, wobei mindestens ein Leuchtdiodenchip (R, G, B) eine Strahlungsleistungsabgabe von mindestens 100 mW aufweist, wenn dieser bei Nennleistung angesteuert wird.

## Revendications

1. Système d'éclairage comprenant :
au moins une puce de diode électroluminescente (R, G, B),
chaque puce de diode électroluminescente (R, G, B) comprenant un substrat de DEL (2) qui est pourvu d'une couche émettrice de lumière (1) pour émettre de la lumière,
l'au moins une puce de diode électroluminescente (R, G, B) étant disposée sur un substrat optique (10),
la couche émettrice de lumière (1) de l'au moins une puce de diode électroluminescente (R, G, B) étant située vis-à-vis du substrat optique (10),
la lumière étant émise par l'au moins une puce de diode électroluminescente (R, G, B) étant émise par le biais de la surface de fenêtre de sortie de lumière (11) du substrat optique (10), la surface de fenêtre de sortie de lumière (11) étant située dans un sens s'éloignant de la couche émettrice de lumière (1),
le substrat optique (10) comprenant des moyens de diffusion de la chaleur où ce substrat optique (10) comprend un matériau translucide, le matériau translucide agissant en tant que moyens de diffusion de la chaleur, le matériau translucide étant translucide à la lumière qui est émise par la puce de diode électroluminescente (R, G, B),
**caractérisé en ce que** le matériau translucide est une céramique polycristalline.

2. Système d'éclairage selon la revendication 1, dans lequel le matériau céramique polycristallin translucide est sélectionné parmi le groupe comprenant du granite d'yttrium et d'aluminium, de l'oxyde d'aluminium polycristallin et du nitrure d'aluminium.

3. Système d'éclairage selon la revendication 1 ou selon la revendication 2, dans lequel les moyens de diffusion de la chaleur comprennent une couche de métallisation (16) qui est déposée d'un côté du substrat optique (10) qui se situe dans un sens s'éloignant de la surface de fenêtre de sortie de lumière (11).

4. Système d'éclairage selon la revendication 1 ou selon la revendication 2, dans lequel les moyens de diffusion de la chaleur comprennent un dissipateur de chaleur (17) qui est appliqué d'un côté du substrat optique (10) étant situé dans un sens s'éloignant de la surface de fenêtre de sortie de lumière (11).

5. Système d'éclairage selon la revendication 1 ou selon la revendication 2, dans lequel l'au moins une puce de diode électroluminescente (R, G, B) est noyée dans le substrat optique (10).

6. Système d'éclairage selon la revendication 1 ou selon la revendication 2, dans lequel le substrat optique (10) comprend :
- du matériau luminescent pour convertir au moins une partie de la lumière qui est émise par la puce de diode électroluminescente (R, G, B) en lumière d'une couleur différente, et/ou
- un indice de réfraction qui est sensiblement égal à l'indice de réfraction de la puce de diode électroluminescente (R, G, B), et/ou
- des structures optiques qui sont sélectionnées parmi le groupe comprenant des microlentilles et des configurations de diffraction.

7. Système d'éclairage selon la revendication 1 ou selon la revendication 2, dans lequel des connexions métalliques (23) sont prévues sur un côté du substrat optique (10) qui se situe dans un sens s'éloignant de la surface de fenêtre de sortie de lumière (11), les connexions métalliques (23) mettant sous tension l'au moins une puce de diode électroluminescente (R, G, B).

8. Système d'éclairage selon la revendication 1 ou selon la revendication 2, dans lequel des moyens transparents de liaison optique sont prévus entre l'au moins une puce de diode électroluminescente (R, G, B) et le substrat optique (10), les moyens transparents de liaison optique comprenant des propriétés d'adaptation de l'indice de réfraction pour réduire ou pour éviter un changement de l'indice de réfraction entre des puces de diode électroluminescente (R, G, B) et le substrat optique.

9. Système d'éclairage selon la revendication 1 ou selon la revendication 2, dans lequel au moins une puce de diode électroluminescente (R, G, B) présente une sortie de puissance rayonnante d'au moins 100 mW lorsqu'elle est excitée à la puissance nominale.
